# EUROPEAN PATENT APPLICATION

(11) **EP 3 481 164 A1**
(43) Date of publication of application: **08.05.2019**
(21) Application number: 17819127.6
(22) Date of filing: 19.06.2017
(51) Int. Cl.: H05K 5/02

(54) **HOUSING AND METHOD FOR FABRICATION THEREOF AND APPLICATION THEREOF**

(30) Priority: 30.06.2016 CN 201610502640
(71) Applicant: BYD Company Limited, Shenzhen, Guangdong 518118 (CN)
(72) Inventor: SUN, Jian, Shenzhen Guangdong 518118 (CN); CHEN, Liang, Shenzhen Guangdong 518118 (CN); ZHAO, Guiwang, Shenzhen Guangdong 518118 (CN); WU, Yingyuan, Shenzhen Guangdong 518118 (CN); JIANG, Xiangrong, Shenzhen Guangdong 518118 (CN); ZOU, Yunfei, Shenzhen Guangdong 518118 (CN)
(74) Representative: Gulde & Partner
(86) International application number: PCT/CN2017/088946
(87) International publication number: WO 2018/001130

(57) **Abstract**

The present disclosure relates to the field of electronic communications, and discloses a housing, a preparation method therefor, and use thereof. The housing includes a metal hard anodic oxide layer (5) and a resin film layer (3) adhering to a first surface of the metal hard anodic oxide layer (5). The metal hard anodic oxide layer (5) and the resin film layer (3) form an integrated structure. The preparation method includes: performing hard anode oxidization treatment on a metal substrate (1), and then successively performing injection molding and etching.

## Description

### CROSS-REFERENCE TO RELATED APPLICATIONS

This application claims priority to and benefits of Chinese Patent Application Serial No. 201610502640.1, filed with the State Intellectual Property Office of P. R. China on June 30, 2016. The entire content of the above-referenced application is incorporated herein by reference.

### FIELD

The present disclosure relates to the field of electronic communications, and specifically, to a housing, a housing preparation method, a housing prepared by using the method, and use of a housing as an electronic product casing.

### BACKGROUND

To meet a requirement on a communication function, in all designs of casings of most mobile phones currently available on the market, non-metallic materials such as plastic, glass, and ceramic that a radio frequency can penetrate through are used. However, metal has been a favourite material for an appearance since ancient times. Because of a beautiful appearance effect of metal, metal is increasingly designed for a mobile phone casing, but metal is a material that a radio frequency cannot penetrate through. To meet both an appearance requirement and a communication requirement of a consumer, in the prior art, usually, metal is connected to plastic, and both of them are used for a casing design. However, due to different appearance effects of metal and plastic, a mobile phone casing achieves an inconsistent and discontinuous overall visual effect.

### SUMMARY

An objective of the present disclosure is to provide a housing, a preparation method therefor, and use thereof, to overcome a disadvantage in the prior art that an electronic product casing achieves an inconsistent and discontinuous overall visual effect.

To achieve the foregoing objective, the present disclosure provides a housing. The housing includes a metal hard anodic oxide layer and a resin film layer adhering to a first surface of the metal hard anodic oxide layer. The metal hard anodic oxide layer and the resin film layer form an integrated structure.

The present disclosure further provides a housing preparation method. The method includes:
providing a metal substrate, and performing hard anode oxidization treatment on the metal substrate, to obtain a base having a surface on which a metal hard anodic oxide is provided;
forming a resin film layer on a first surface of the base, to obtain a first composite;
performing alkaline etching on the first composite, to remove, from the surface of the base, a metal hard anodic oxide on which a resin film layer is not formed, to obtain a second composite, where the second composite includes the metal substrate, the metal hard anodic oxide layer, and the resin film layer; and
performing acidic etching on the second composite, to remove the metal substrate from the base.

The present disclosure further provides a housing prepared by using the method in the present disclosure.

The present disclosure further provides use of the housing in the present disclosure as an electronic product casing.

The housing provided in the present disclosure has a neat, smooth, even, and consistent appearance; and the metal hard anodic oxide layer can present a metallic visual effect, to meet a requirement of a consumer on an appearance effect. In addition, the metal hard anodic oxide layer and the resin film layer are both nonmetal materials, and a radio frequency can penetrate through both the metal hard anodic oxide layer and the resin film layer. Therefore, when the housing in the present disclosure is used as an electronic product casing, particularly a communications device casing (such as a mobile phone casing), the housing does not interfere with a communication function.

In addition, for the housing in the present disclosure, the metal hard anodic oxide layer and the resin film layer may be integrally molded through injection molding. In this way, it is more convenient to implement a structural design of the electronic product casing, and a problem of an inconsistent appearance effect is resolved.

Other features and advantages of the present disclosure are described in detail in the Detailed Description part below.

### BRIEF DESCRIPTION OF THE DRAWINGS

The accompanying drawings are used to provide further understanding of the present disclosure, constitute a part of this specification, and are used, together with the following specific implementations, to explain the present disclosure, but do not constitute limitations to the present disclosure. In the accompanying drawings:
Fig. 1 is a schematic sectional view of a pretreated metal substrate;
Fig. 2 is a schematic sectional view of a base obtained after hard anode oxidization treatment;
Fig. 3 is a schematic sectional view of a first composite obtained after injection molding;
Fig. 4 is a schematic sectional view of a second composite obtained by removing, from a surface of a base, a metal hard anodic oxide on which a resin film layer is not formed;
Fig. 5 is a schematic sectional view of a housing from which a metal substrate is removed; and
Fig. 6 is a schematic sectional view of a dyed housing.

### Description of Reference Numerals:

1: Metal substrate; 2: Metal hard anodic oxide;
3: Resin film layer; 4: Dye layer;
5: Metal hard anodic oxide layer

### DETAILED DESCRIPTION

Specific implementations of the present disclosure are described in detail below. It should be understood that the specific implementations described herein are merely used to describe and explain the present disclosure rather than limit the present disclosure.

Endpoints and any values of ranges disclosed in this specification are not limited to the precise ranges or values, and these ranges or values should be understood as including values close to the ranges or the values. For value ranges, endpoint values of the ranges, the endpoint values of the ranges and separate point values, and the separate point values can be combined with each other to obtain one or more new value ranges. These value ranges should be construed as being specifically disclosed in this specification.

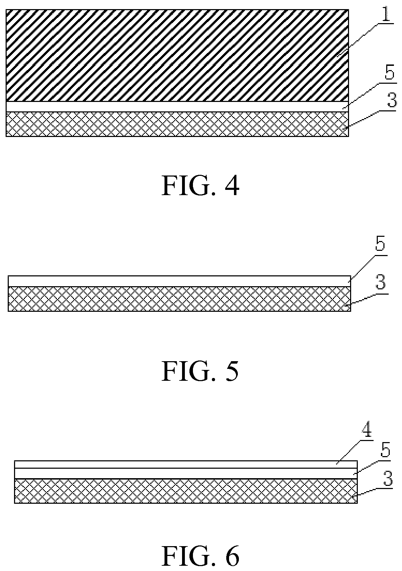

The present disclosure provides a housing. As shown in Fig. 5, the housing includes a metal hard anodic oxide layer 5 and a resin film layer 3 adhering to a first surface of the metal hard anodic oxide layer 5. The metal hard anodic oxide layer 5 and the resin film layer 3 form an integrated structure.

In the present disclosure, the term "integrated structure" means that the metal hard anodic oxide layer 5 and the resin film layer 3 are closely and seamlessly bonded, and no inconsistent appearance is presented.

Particularly, the metal hard anodic oxide layer 5 is formed by aluminum or aluminum alloy through hard anode oxidization. The aluminum alloy is alloy formed by adding aluminum as a basic element into another element, and may be various types of common aluminum alloy.

According to an implementation of the present disclosure, the metal hard anodic oxide layer 5 has a double-layer pore structure. The double-layer pore structure includes an inner layer having a macro pore structure and an outer layer having a micro pore structure. The resin film layer 3 is bonded to the inner layer having the macro pore structure. The macro pore and the micro pore may be used to accommodate a resin composition, to anchor the resin film layer 3 to the surface of the metal hard anodic oxide layer 5, so that the resin film layer 3 and the metal hard anodic oxide layer 5 can be closely and seamlessly bonded. In the present disclosure, the "macro pore" and the "micro pore" are relative concepts, and are mainly used to describe a case in which pore structures of different sizes are distributed in different parts of the metal hard anodic oxide layer 5.

In the present disclosure, the sizes of the macro pore and the micro pore in the metal hard anodic oxide layer 5 are not particularly limited, and may be conventional choices in the art. However, to further improve bonding strength between the resin film layer 3 and the metal hard anodic oxide layer 5, and avoid causing adverse impact to the strength of the metal hard anodic oxide layer 5, optionally, the pore size of the macro pore is within a range of 200-2000 nm, and is particularly within a range of 500-1800 nm, for example, within a range of 1000-1500 nm; and the pore size of the micro pore is within a range of 10-100 nm, and is particularly within a range of 20-70 nm, for example, within a range of 30-60 nm.

In the present disclosure, the thickness of the metal hard anodic oxide layer 5 is not particularly limited, and may be a conventional choice in the art. However, to optimize the space of a pore structure, and achieve a higher binding force between the resin film layer 3 and the metal hard anodic oxide layer 5, optionally, the thickness of the metal hard anodic oxide layer 5 is within a range of 5-90 µm, and is particularly within a range of 10-70 µm, for example, within a range of 12-45 µm.

In the present disclosure, the hardness of the metal hard anodic oxide layer 5 is not particularly limited, and may be a conventional choice in the art. However, to improve the performance of the housing, optionally, the hardness of the metal hard anodic oxide layer 5 is within a range of is 350-800 HV, and is particularly within a range of 450-600 HV.

In the present disclosure, a component of the resin film layer 3 is not particularly limited, provided that the resin film layer 3 can be acid-alkaline resistant, and there is a relatively high binding force between the resin film layer 3 and the metal hard anodic oxide layer 5. Optionally, the resin film layer 3 is formed by a resin composition containing thermoplastic resin and any filler.

In the present disclosure, the content of the thermoplastic resin in the resin composition and the content of the filler in the resin composition are not particularly limited, and may be conventional choices in the art. Optionally, the resin composition contains 50-99 wt% of thermoplastic resin and 1-50 wt% of filler, and particularly, the resin composition contains 60-75 wt% of thermoplastic resin and 25-40 wt% of filler.

In the present disclosure, a choice of the thermoplastic resin is not particularly limited, and may be a conventional choice in the art. Optionally, the thermoplastic resin is at least one of polyphenylene sulfide (PPS), polyphenylene oxide, and polyamide, and is particularly PPS.

In the present disclosure, a choice of the filler is not particularly limited, and may be a conventional choice in the art. Optionally, the filler is a fibrous filler and/or a powder filler.

In the present disclosure, a choice of the fibrous filler is not particularly limited, and may be a conventional choice in the art. Optionally, the fibrous filler is at least one of glass fiber, carbon fiber, and polyamide fiber, and is particularly glass fiber.

In the present disclosure, a choice of the powder filler is not particularly limited, and may be a conventional choice in the art. Optionally, the powder filler is at least one of silica, talcum powder, aluminum hydroxide, magnesium hydroxide, calcium carbonate, magnesium carbonate, glass, and kaolinite, and is particularly at least one of silica, talcum powder, aluminum hydroxide, and magnesium hydroxide.

In the present disclosure, the thickness of the resin film layer 3 is not particularly limited, and may be selected according to a specific use requirement. Optionally, the thickness of the resin film layer 3 is within a range of 0.1-10 mm, and is particularly within a range of 0.2-8 mm, for example, within a range of 0.4-5 mm. In the present disclosure, the thickness of the resin film layer 3 is a vertical distance between an upper surface of the metal hard anodic oxide layer 5 and an upper surface of the resin film layer 3.

To achieve a better appearance effect of the housing, as shown in Fig. 6, the housing may further include a dye layer 4. The dye layer 4 is formed on a second surface of the metal hard anodic oxide layer 5 and is opposite to the resin film layer 3. In the present disclosure, a color of the dye layer 4 is not particularly limited, and may be selected according to a requirement and an appearance effect, for example, may be silver, white, or gold.

The present disclosure further provides a housing preparation method. The method includes:
providing a metal substrate 1, and performing hard anode oxidization treatment on the metal substrate 1, to obtain a base having a surface on which a metal hard anodic oxide 2 is provided;
forming a resin film layer 3 on a first surface of the base, to obtain a first composite;
performing alkaline etching on the first composite, to remove, from the surface of the base, a metal hard anodic oxide 2 on which a resin film layer 3 is not formed, to obtain a second composite, where the second composite includes the metal substrate 1, the metal hard anodic oxide layer 5, and the resin film layer 3; and
performing acidic etching on the second composite, to remove the metal substrate 1 from the base.

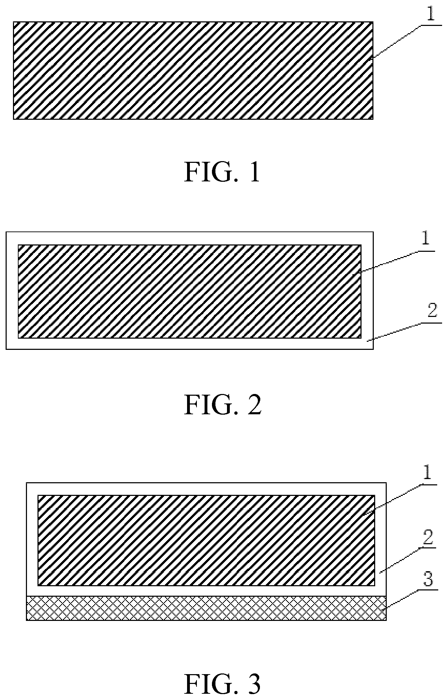

In the present disclosure, an implementation of the hard anode oxidization treatment is not particularly limited, and the hard anode oxidization treatment may be performed on the metal substrate 1 in a conventional manner in the art, to obtain the base having the surface on which the metal hard anodic oxide 2 is provided. Specifically, during the hard anode oxidization treatment, the metal substrate 1 may be placed in the electrolytic solution. The metal substrate 1 is used as an anode, a conductive material that does not react with an electrolytic solution is used as a cathode, the cathode and the anode are respectively electrically connected to a positive electrode and a negative electrode of a power supply, and after energization, the hard anode oxidization treatment is performed, to form the metal hard anodic oxide 2 on the surface of the metal substrate 1, as shown in Fig. 2.

In the present disclosure, a condition for the hard anode oxidization treatment is not particularly limited, and may be selected based on an expected thickness of the metal hard anodic oxide 2. Optionally, the condition for the hard anode oxidization treatment includes: a current density is within a range of 0.1-10 A/dm², and is particularly within a range of 1.5-5 A/dm²; a temperature is within a range of 0-20°C, and is particularly within a range of 2-10°C; a time is within a range of 1-300 min, and is particularly within a range of 30-120 min; and the concentration of the electrolytic solution is within a range of 10-260 g/L, and is particularly within a range of 30-180 g/L.

In the present disclosure, a choice of an electrolyte in the electrolytic solution is not particularly limited, and may be a conventional choice in the art. For example, the electrolyte may be at least one of sulfuric acid, oxalic acid, methanoic acid, and citric acid, and is particularly sulfuric acid and/or oxalic acid, for example, sulfuric acid and oxalic acid.

When the electrolyte in the electrolytic solution is sulfuric acid and oxalic acid, the concentration of sulfuric acid in the electrolytic solution and the concentration of oxalic acid in the electrolytic solution are not particularly limited in the present disclosure. Optionally, when the electrolyte of the electrolytic solution is sulfuric acid and oxalic acid, the concentration of sulfuric acid in the electrolytic solution is within a range of 25-225 g/L, and is particularly within a range of 100-200 g/L, for example, within a range of 150-180 g/L; and the concentration of oxalic acid in the electrolytic solution is within a range of 5-35 g/L, and is particularly within a range of 10-25 g/L, for example, within a range of 15-20 g/L.

The metal hard anodic oxide 2 is formed on the surface of the metal substrate 1 subjected to the hard anode oxidization treatment. The metal hard anodic oxide 2 has a micro pore whose pore size is within a range of 10-100 nm and is particularly within a range of 20-70 nm, for example, within a range of 30-60 nm. According to an implementation of the present disclosure, to firmly bond the subsequently formed resin film layer 3 to the metal hard anodic oxide layer 5, after the hard anode oxidization treatment and before the resin film layer 3 is formed, pore expanding is performed on the surface of the base obtained after the hard anode oxidization treatment.

In the present disclosure, based on a condition for the pore expanding, a macro pore whose pore size is within a range of 200-2000 nm and is particularly within a range of 500-1800 nm, for example, within a range of 1000-1500 nm is formed on a surface of the metal hard anodic oxide 2.

In the present disclosure, the pore expanding process is performed in a pore-expanding agent. The concentration of the pore-expanding agent is not particularly limited in the present disclosure, and may be a conventional choice in the art. Optionally, the concentration of the pore-expanding agent is within a range of 0.1-40 g/L, and is particularly within a range of 10-20 g/L.

A choice of the pore-expanding agent is not particularly limited in the present disclosure, provided that an objective of pore expanding in the present disclosure can be achieved. Optionally, the pore-expanding agent is at least one of an aqueous sodium carbonate solution, an aqueous sodium bicarbonate solution, an aqueous sodium hydroxide solution, an aqueous potassium carbonate solution, an aqueous potassium bicarbonate solution, an aqueous potassium hydroxide solution, an aqueous sodium hydrogen phosphate solution, an aqueous potassium hydrogen phosphate solution, an aqueous sodium dihydrogen phosphate solution, an aqueous potassium dihydrogen phosphate solution, an aqueous sodium hydroxide-sodium hydrogen phosphate solution, an aqueous potassium hydroxide-potassium hydrogen phosphate solution, an ammonia solution, an aqueous hydrazine solution, an aqueous hydrazine derivative solution, a water-soluble amine compound aqueous solution, an aqueous ammonium-ammonium chloride solution, an aqueous sodium phosphate-sodium hydrogen phosphate solution, and an aqueous potassium phosphate-potassium hydrogen phosphate solution, and is particularly at least one of an aqueous sodium dihydrogen phosphate solution, an aqueous potassium dihydrogen phosphate solution, an aqueous sodium hydroxide-sodium hydrogen phosphate solution, and an aqueous potassium hydroxide-potassium hydrogen phosphate solution, for example, an aqueous sodium dihydrogen phosphate solution.

In the present disclosure, the method of providing a metal substrate 1 may be as follows: Metal was ground in a polisher and then washed with anhydrous ethanol. Then the metal was immersed in a 40-60 g/L aqueous sodium hydroxide solution, and the metal was removed after 1-5 min, and washed with deionized water, to obtain the metal substrate 1 having a clean and even surface, as shown in Fig. 1. The metal may be aluminum or aluminum alloy.

In the present disclosure, a manner of forming the resin film layer 3 includes: performing injection molding by using a resin composition. The resin composition is filled in the macro pore and the micro pore in the metal hard anodic oxide 2, and the resin film layer 3 firmly bonded to the metal hard anodic oxide 2 is formed on the surface of the metal hard anodic oxide 2, as shown in Fig. 3.

In the present disclosure, the constitution of the resin composition is not particularly limited, provided that the resin film layer 3 can be acid-alkaline resistant, and there is a relatively high binding force between the resin film layer 3 and the metal hard anodic oxide 2. Optionally, the resin composition contains 50-99 wt% of thermoplastic resin and 1-50 wt% of filler, and particularly, the resin composition contains 60-75 wt% of thermoplastic resin and 25-40 wt% of filler.

In the present disclosure, a choice of the thermoplastic resin is not particularly limited, and may be a conventional choice in the art. For example, the thermoplastic resin may be at least one of PPS, polyphenylene oxide, and polyamide.

In the present disclosure, a choice of the filler is not particularly limited, and may be a conventional choice in the art. For example, the filler may be a fibrous filler and/or a powder filler.

In the present disclosure, a choice of the fibrous filler is not particularly limited, and may be a conventional choice in the art. For example, the fibrous filler may be at least one of glass fiber, carbon fiber, and polyamide fiber.

In the present disclosure, a choice of the powder filler is not particularly limited, and may be a conventional choice in the art. For example, the powder filler may be at least one of silica, talcum powder, aluminum hydroxide, magnesium hydroxide, calcium carbonate, magnesium carbonate, glass, and kaolinite.

In the present disclosure, the alkaline etching is performed to remove, from the surface of the base, the metal hard anodic oxide 2 on which the resin film layer 3 is not formed. Specifically, the first composite was placed in an etching solution A for the alkaline etching, and removed after the alkaline etching was completed, to obtain the second composite including the metal substrate 1, the metal hard anodic oxide layer 5, and the resin film layer 3; and the second composite was washed with deionized water. The obtained second composite is shown in Fig. 4.

In the present disclosure, the concentration of the etching solution A used in the alkaline etching is not particularly limited, provided that the metal hard anodic oxide 2 on which the resin film layer 3 is not formed can be removed from the surface of the base. Optionally, the concentration of the etching solution A used in the alkaline etching is within a range of 5-60 g/L, and is particularly within a range of 30-50 g/L.

In the present disclosure, a choice of the etching solution A used in the alkaline etching is not particularly limited, and may be a conventional choice in the art. Optionally, the etching solution A contains at least one of sodium hydroxide, potassium hydroxide, and sodium carbonate, and particularly contains sodium hydroxide and/or potassium hydroxide, for example, sodium hydroxide.

In the present disclosure, a condition for the alkaline etching is not particularly limited, provided that the metal hard anodic oxide 2 on which the resin film layer 3 is not formed can be effectively removed from the surface of the base. Optionally, the condition for the alkaline etching includes: a temperature is within a range of 20-80°C, and is particularly within a range of 40-60°C; and a time is within a range of 0.1-10 min, and is particularly within a range of 0.5-3 min.

In the present disclosure, the acidic etching is performed to remove the metal substrate 1 from the base. Specifically, the second composite was placed in an etching solution B for the acidic etching, removed after the acidic etching was completed, and washed with deionized water. An obtained housing is shown in Fig. 5.

In the present disclosure, the concentration of the etching solution B used in the acidic etching is not particularly limited, provided that the metal substrate 1 can be removed from the base. Optionally, the concentration of the etching solution B used in the acidic etching is within a range of 1-900 g/L, and is particularly within a range of 300-800 g/L.

In the present disclosure, a choice of the etching solution B used in the acidic etching is not particularly limited. Optionally, the etching solution B contains at least one of ferric chloride, hydrochloric acid, and cupric chloride, and particularly contains ferric chloride and hydrochloric acid. When the etching solution B is a mixture of ferric chloride and hydrochloric acid, a weight ratio of ferric chloride to hydrochloric acid ranges from 1: 10 to 10: 1.

In the present disclosure, a condition for the acidic etching is not particularly limited, and may be a conventional choice in the art. However, to effectively remove the metal substrate 1 from the base, the condition for the acidic etching includes: a temperature is within a range of 5-40°C, and is particularly within a range of 20-30°C; and a time is within a range of 1-60 min, and is particularly within a range of 15-30 min.

According to an implementation of the present disclosure, to remove a pore on the surface and improve a color variance on the surface caused due to etching, the method may further include: dyeing and pore sealing a lower surface of the metal hard anodic oxide layer 5 on which the resin film layer 3 is not formed. Specifically, the dyeing process may be performed in a dye bath. A dye color is not particularly limited in the present disclosure, and may be selected according to a requirement and an appearance effect, for example, may be silver, white, or gold. After the dyeing was completed, the lower surface was washed with deionized water. A dyed housing is shown in Fig. 6. The pore sealing process may be performed in a pore sealing groove.

The present disclosure further provides a housing prepared by using the method in the present disclosure. The housing includes a metal hard anodic oxide layer 5 and a resin film layer 3. The metal hard anodic oxide layer 5 and the resin film layer 3 form an integrated structure. The metal hard anodic oxide layer 5 has a double-layer pore structure. The double-layer pore structure includes an inner layer having a macro pore structure and an outer layer having a micro pore structure. The resin film layer 3 is bonded to the inner layer having the macro pore structure. The housing has a neat, smooth, consistent, and continuous appearance.

The present disclosure further provides use of the housing in the present disclosure as an electronic product casing. The electronic product casing may be casings of various electronic products (such as communications devices) that need to use metal as casings, for example, may be a casing or an outer frame of a mobile terminal, or a casing or an outer frame of a wearable electronic device. The mobile terminal may be a device in a mobile state that has a wireless transmission function, for example, a mobile phone or a portable computer (including a notebook computer and a tablet computer). The wearable electronic device is an intelligent wearable device, for example, may be a smartwatch or a smart band. The electronic product may be specifically, but is not limited to, at least one of a mobile phone, a portable computer (such as a notebook computer and a tablet computer), a smartwatch, and a smart band.

Particularly, the electronic product casing is a mobile phone housing. The mobile phone housing has an all-metal appearance effect, and the housing has a neat, smooth, consistent, and continuous appearance, and a radio frequency can penetrate through the housing.

The present disclosure is described in detail below by using examples.

In the following examples and comparative examples, the thickness of a metal hard anodic oxide is measured by using a metallurgical microscope of a model Axio Imager Aim purchased from ZEISS.

The hardness of the metal hard anodic oxide is measured by using a microhardness tester of a model HX-1000TM/LCD purchased from Shanghai No.1 Optical Instrument Factory.

The pore size of a pore is measured by using a scanning electron microscope of a model JSM-7600F purchased from Japan Electron Optics Laboratory (five different positions of a same sample are observed to measure the pore sizes of all pores that appear within a range of a field of view).

In the following examples and comparative examples, an aluminum alloy plate is purchased from Alnan Aluminium Inc.

### Example 1

In this example, a housing preparation method is described.
(1) A commercially available 1-mm thick 5052 aluminum alloy plate was cut into a 15 mm^{∗}80 mm rectangular sheet. The aluminum alloy plate was ground in a polisher and then washed with anhydrous ethanol. Then the aluminum alloy substrate was immersed in a 50 g/L aqueous sodium hydroxide solution, removed after 2 min, and washed with deionized water, to obtain a pretreated aluminum alloy sheet shown in Fig. 1.
(2) The aluminum alloy sheet as an anode was placed in a hard anode oxidization tank containing 150 g/L sulfuric acid and 15 g/L oxalic acid, subjected to hard anode oxidization for 30 min at 6°C and a current density of 1.5 A/dm², and washed and blown dry, to obtain a base having a surface on which a metal hard anodic oxide is provided, as shown in Fig. 2. The thickness of the metal hard anodic oxide was measured by using the metallurgical microscope, and the hardness of the metal hard anodic oxide was measured by using the microhardness tester. The result is shown in Table 1.
(3) 100 ml of a 10 g/L aqueous sodium dihydrogen phosphate solution was prepared in a beaker, in which the base obtained in the step (2) was immersed at 20°C for pore expanding. The base was removed after 60 min, immersed in a beaker containing water for 1 min, and then blown dry. The pore size of a pore in the metal hard anodic oxide was measured by using the scanning electron microscope. The result is shown in Table 1.
(4) The dried base was inserted into an injection mold, injection molded with a resin composition containing 25 wt% of glass fiber and 75 wt% of PPS, and released from the mold, and cooled to obtain a first aluminum alloy-resin composite in which aluminum alloy is firmly bonded to the resin composition, as shown in Fig. 3.
(5) The first aluminum alloy-resin composite obtained after the injection molding was placed in a 40 g/L aqueous sodium hydroxide solution, immersed for 1 min at 40°C and then removed and washed with deionized water. A metal hard anodic oxide in an area in which injection molding does not occur was removed by alkaline etching, to obtain a second aluminum alloy-resin composite including an aluminum alloy layer, a metal hard anodic oxide layer, and a resin film layer, as shown in Fig. 4.
(6) The second aluminum alloy-resin composite obtained after the alkaline etching was placed in a 300 g/L mixed solution of ferric chloride and hydrochloric acid (at a weight ratio of ferric chloride to hydrochloric acid of 1: 1) for acidic etching at a temperature of 30°C for 18 min, to remove the aluminum alloy layer. After the acidic etching was completed, the resulting product was washed with deionized water, to obtain a housing shown in Fig. 5.
(7) The housing obtained after the acidic etching was placed and dyed in a dye bath with a matched color for 10 min, and after the dyeing was completed, the housing was washed with deionized water, to obtain a housing shown in Fig. 6.
(8) The dyed housing was placed and pore sealed in a pore sealing groove for 10 min.

### Example 2

In this example, a housing preparation method is described.
(1) A commercially available 1-mm thick 5052 aluminum alloy plate was cut into a 15 mm^{∗}80 mm rectangular sheet. The aluminum alloy plate was ground in a polisher and then washed with anhydrous ethanol. Then the aluminum alloy substrate was immersed in a 40 g/L aqueous sodium hydroxide solution, removed after 1 min, and washed with deionized water, to obtain a pretreated aluminum alloy sheet shown in Fig. 1.
(2) The aluminum alloy sheet as an anode was placed in a hard anode oxidization tank containing 160 g/L sulfuric acid and 18 g/L oxalic acid, subjected to hard anode oxidization for 60 min at 5°C and a current density of 3 A/dm², and washed and blown dry, to obtain a base having a surface on which a metal hard anodic oxide is provided, as shown in Fig. 2. The thickness of the metal hard anodic oxide was measured by using the metallurgical microscope, and the hardness of the metal hard anodic oxide was measured by using the microhardness tester. The result is shown in Table 1.
(3) 100 ml of a 15 g/L aqueous sodium hydroxide-sodium hydrogen phosphate solution was prepared in a beaker, in which the base obtained in the step (2) was immersed at 20°C for pore expanding. The base was removed after 60 min, immersed in a beaker containing water for 1 min, and then blown dry. The pore size of a pore in the metal hard anodic oxide was measured by using the scanning electron microscope. The result is shown in Table 1.
(4) The dried base was inserted into an injection mold, injection molded with a resin composition containing 35 wt% of glass fiber and 65 wt% of polyphenylene oxide, and released from the mold, and cooled to obtain a first aluminum alloy-resin composite in which aluminum alloy is firmly bonded to the resin composition, as shown in Fig. 3.
(5) The first aluminum alloy-resin composite obtained after the injection molding was placed in a 30 g/L aqueous sodium hydroxide solution, immersed for 0.5 min at 50°C and then removed and washed with deionized water. A metal hard anodic oxide in an area in which injection molding does not occur was removed by alkaline etching, to obtain a second aluminum alloy-resin composite including an aluminum alloy layer, a metal hard anodic oxide layer, and a resin film layer, as shown in Fig. 4.
(6) The second aluminum alloy-resin composite obtained after the alkaline etching was placed in a 600 g/L mixed solution of ferric chloride and hydrochloric acid (at a weight ratio of ferric chloride to hydrochloric acid of 2: 1) for acidic etching at a temperature of 20°C for 15 min, to remove the aluminum alloy layer. After the acidic etching was completed, the resulting product was washed with deionized water, to obtain a housing shown in Fig. 5.
(7) The housing obtained after the acidic etching was placed and dyed in a dye bath with a matched color for 10 min, and after the dyeing was completed, the housing was washed with deionized water, to obtain a housing shown in Fig. 6.
(8) The dyed housing was placed and pore sealed in a pore sealing groove for 10 min.

### Example 3

In this example, a housing preparation method is described.
(1) A commercially available 1-mm thick 5052 aluminum alloy plate was cut into a 15 mm^{∗}80 mm rectangular sheet. The aluminum alloy plate was ground in a polisher and then washed with anhydrous ethanol. Then the aluminum alloy substrate was immersed in a 60 g/L aqueous sodium hydroxide solution, removed after 5 min, and washed with deionized water, to obtain a pretreated aluminum alloy sheet shown in Fig. 1
(2) The aluminum alloy sheet as an anode was placed in a hard anode oxidization tank containing 180 g/L sulfuric acid and 20 g/L oxalic acid, subjected to hard anode oxidization for 120 min at 10°C and a current density of 5 A/dm², and washed and blown dry, to obtain a base having a surface on which a metal hard anodic oxide is provided, as shown in Fig. 2. The thickness of the metal hard anodic oxide was measured by using the metallurgical microscope, and the hardness of the metal hard anodic oxide was measured by using the microhardness tester. The result is shown in Table 1.
(3) 100 ml of a 20 g/L aqueous potassium dihydrogen phosphate solution was prepared in a beaker, in which the base obtained in the step (2) was immersed at 20°C for pore expanding. The base was removed after 60 min, immersed in a beaker containing water for 1 min, and then blown dry. The pore size of a pore in the metal hard anodic oxide was measured by using the scanning electron microscope. The result is shown in Table 1.
(4) The dried base was inserted into an injection mold, injection molded with a resin composition containing 40 wt% of silica and 60 wt% of PPS, and released from the mold, and cooled to obtain a first aluminum alloy-resin composite in which aluminum alloy is firmly bonded to the resin composition, as shown in Fig. 3.
(5) The first aluminum alloy-resin composite obtained after the injection molding was placed in a 50 g/L aqueous sodium hydroxide solution, immersed for 3 min at 60°C and then removed and washed with deionized water. A metal hard anodic oxide in an area in which injection molding does not occur was removed by alkaline etching, to obtain a second aluminum alloy-resin composite including an aluminum alloy layer, a metal hard anodic oxide layer, and a resin film layer, as shown in Fig. 4.
(6) The second aluminum alloy-resin composite obtained after the alkaline etching was placed in a 800 g/L mixed solution of ferric chloride and hydrochloric acid (at a weight ratio of ferric chloride to hydrochloric acid of 4: 1) for acidic etching at a temperature of 25°C for 30 min, to remove the aluminum alloy layer. After the acidic etching was completed, the resulting product was washed with deionized water, to obtain a housing shown in Fig. 5.
(7) The housing obtained after the acidic etching was placed and dyed in a dye bath with a matched color for 10 min, and after the dyeing was completed, the housing was washed with deionized water, to obtain a housing shown in Fig. 6.
(8) The dyed housing was placed and pore sealed in a pore sealing groove for 10 min.

### Example 4

In this example, a housing prepared when a pore-expanding agent is an aqueous ammonium-ammonium chloride solution is described.

The housing is prepared by using the method in Example 1, and a difference lies in that in the step (3), the pore-expanding agent is the aqueous ammonium-ammonium chloride solution. The measurement result is shown in Table 1.

### Example 5

In this example, a housing prepared when the concentration of a pore-expanding agent is not within an optimal range but is within a relatively large range of the present disclosure is described.

The housing is prepared by using the method in Example 1, and a difference lies in that in the step (3), the concentration of the pore-expanding agent is 5 g/L. The measurement result is shown in Table 1.

### Example 6

In this example, a housing prepared without a pore expanding step is described.

The housing is prepared by using the method in Example 1, and a difference lies in that there is no pore expanding process in the step (3), to be specific, the injection molding process in the step (4) is directly performed on the base obtained in the step (2) and having the surface on which the metal hard anodic oxide is provided. The measurement result is shown in Table 1.

**Table 1**

| Number | Thickness of the metal hard anodic oxide /µm | Hardness of the metal hard anodic oxide /HV | Pore size of a micro pore /nm | Pore size of a macro pore /nm |
|---|---|---|---|---|
| Example 1 | 28 | 357 | 20-40 | 800-1200 |
| Example 2 | 36 | 439 | 30-60 | 1000-1500 |
| Example 3 | 56 | 567 | 50-80 | 1200-1800 |
| Example 4 | 27 | 341 | 20-40 | 600-1000 |
| Example 5 | 29 | 368 | 20-40 | 400-800 |
| Example 6 | 30 | 332 | 20-40 | - |

It can be learned from the results in the foregoing examples that, the hardness of the housing prepared by using the method in the present disclosure meets a requirement that the housing can be used as an electronic product casing (the hardness is greater than 180 HV). The housing as an electronic product casing achieves an all-metal appearance effect with a neat, smooth, even, consistent, and continuous surface, and in the housing prepared by using the method in the present disclosure, resin is filled in the macro pore and the micro pore, to closely bond the metal hard anodic oxide layer to the resin film layer, thereby improving the performance of the housing.

Although specific implementations of the present disclosure are described in detail above, the present disclosure is not limited to specific details in the foregoing implementations. Various simple variations can be made to the technical solutions of the present disclosure within the scope of the technical idea of the present disclosure, and such simple variations all fall within the protection scope of the present disclosure.

It should be further noted that the specific technical features described in the foregoing specific implementations can be combined in any appropriate manner provided that no conflict occurs. To avoid unnecessary repetition, various possible combination manners will not be otherwise described in the present disclosure.

In addition, various different implementations of the present disclosure may alternatively be combined randomly. Such combinations should also be considered as the content disclosed in the present disclosure provided that these combinations do not depart from the idea of the present disclosure.

## Claims

1. A housing, comprising a metal hard anodic oxide layer (5) and a resin film layer (3) adhering to a first surface of the metal hard anodic oxide layer (5), wherein the metal hard anodic oxide layer (5) and the resin film layer (3) form an integrated structure.

2. The housing according to claim 1, wherein the thickness of the metal hard anodic oxide layer (5) is within a range of 5-90 µm, is preferably within a range of 10-70 µm, and is further preferably within a range of 12-45 µm; and
preferably, the hardness of the metal hard anodic oxide layer (5) is within a range of is 350-800 HV, and is further preferably within a range of is 450-600 HV.

3. The housing according to claim 1 or 2, wherein the metal hard anodic oxide layer (5) has a double-layer pore structure, the double-layer pore structure comprises an inner layer having a macro pore structure and an outer layer having a micro pore structure, and the resin film layer (3) is bonded to the inner layer having the macro pore structure.

4. The housing according to claim 3, wherein the pore size of a macro pore is within a range of 200-2000 nm, and the pore size of a micro pore is within a range of 10-100 nm.

5. The housing according to claim 1 or 2, wherein the metal hard anodic oxide layer (5) is formed by aluminum or aluminum alloy through hard anode oxidization.

6. The housing according to claim 1, wherein the thickness of the resin film layer (3) is within a range of 0.1-10 mm, is preferably within a range of 0.2-8 mm, and is further preferably within a range of 0.4-5 mm.

7. The housing according to claim 1 or 6, wherein the resin film layer (3) is formed by a resin composition containing thermoplastic resin and any filler;
preferably, the resin composition contains 50-99 wt% of thermoplastic resin and 1-50 wt% of filler;
preferably, the thermoplastic resin is at least one of polyphenylene sulfide (PPS), polyphenylene oxide, and polyamide; and
preferably, the filler is a fibrous filler and/or a powder filler; and further preferably, the fibrous filler is at least one of glass fiber, carbon fiber, and polyamide fiber, and the powder filler is at least one of silica, talcum powder, aluminum hydroxide, magnesium hydroxide, calcium carbonate, magnesium carbonate, glass, and kaolinite.

8. The housing according to claim 1, 2, or 6, wherein the housing further comprises a dye layer (4), and the dye layer (4) is formed on a second surface of the metal hard anodic oxide layer (5) and is opposite to the resin film layer (3).

9. A housing preparation method, comprising:
providing a metal substrate (1), and performing hard anode oxidization treatment on the metal substrate (1), to obtain a base having a metal hard anodic oxide;
forming a resin film layer (3) on a first surface of the base, to obtain a first composite;
performing alkaline etching on the first composite, to remove, from a surface of the base, a metal hard anodic oxide (2) on which a resin film layer (3) is not formed, to obtain a second composite, wherein the second composite comprises the metal substrate (1), the metal hard anodic oxide layer (5), and the resin film layer (3); and
performing acidic etching on the second composite, to remove the metal substrate (1) from the base.

10. The method according to claim 9, wherein after the hard anode oxidization treatment and before the resin film layer (3) is formed on the first surface of the base, pore expanding is performed on the surface of the base.

11. The method according to claim 10, wherein the pore expanding process is performed in a pore-expanding agent, and the concentration of the pore-expanding agent is within a range of 0.1-40 g/L; and
preferably, the pore-expanding agent is at least one of an aqueous sodium carbonate solution, an aqueous sodium bicarbonate solution, an aqueous sodium hydroxide solution, an aqueous potassium carbonate solution, an aqueous potassium bicarbonate solution, an aqueous potassium hydroxide solution, an aqueous sodium hydrogen phosphate solution, an aqueous potassium hydrogen phosphate solution, an aqueous sodium dihydrogen phosphate solution, an aqueous potassium dihydrogen phosphate solution, an aqueous sodium hydroxide-sodium hydrogen phosphate solution, an aqueous potassium hydroxide-potassium hydrogen phosphate solution, an ammonia solution, an aqueous hydrazine solution, an aqueous hydrazine derivative solution, a water-soluble amine compound aqueous solution, an aqueous ammonium-ammonium chloride solution, an aqueous sodium phosphate-sodium hydrogen phosphate solution, and an aqueous potassium phosphate-potassium hydrogen phosphate solution, is further preferably at least one of an aqueous sodium dihydrogen phosphate solution, an aqueous potassium dihydrogen phosphate solution, an aqueous sodium hydroxide-sodium hydrogen phosphate solution, and an aqueous potassium hydroxide-potassium hydrogen phosphate solution, and is more preferably an aqueous sodium dihydrogen phosphate solution.

12. The method according to claim 9 or 10, wherein a condition for the hard anode oxidization treatment comprises: a current density is within a range of 0.1-10 A/dm² and is preferably within a range of 1.5-5 A/dm²; a temperature is within a range of 0-20°C and is preferably within a range of 2-10°C; a time is within a range of 1-300 min and is preferably within a range of 30-120 min; and the concentration of an electrolytic solution is within a range of 10-260 g/L and is preferably within a range of 30-180 g/L;
preferably, an electrolyte in the electrolytic solution is at least one of sulfuric acid, oxalic acid, methanoic acid, and citric acid, is further preferably sulfuric acid and/or oxalic acid, and is more preferably sulfuric acid and oxalic acid; and
further preferably, when the electrolyte in the electrolytic solution is sulfuric acid and oxalic acid, the concentration of sulfuric acid in the electrolytic solution is within a range of 18-200 g/L, and the concentration of oxalic acid in the electrolytic solution is within a range of 5-35 g/L.

13. The method according to claim 9 or 10, wherein a manner of forming the resin film layer (3) comprises: performing injection molding by using a resin composition;
preferably, the resin composition contains 50-99 wt% of thermoplastic resin and 1-50 wt% of filler;
preferably, the thermoplastic resin is at least one of polyphenylene sulfide (PPS), polyphenylene oxide, and polyamide; and
preferably, the filler is a fibrous filler and/or a powder filler; and further preferably, the fibrous filler is at least one of glass fiber, carbon fiber, and polyamide fiber, and the powder filler is at least one of silica, talcum powder, aluminum hydroxide, magnesium hydroxide, calcium carbonate, magnesium carbonate, glass, and kaolinite.

14. The method according to claim 9 or 10, wherein the concentration of an etching solution A used in the alkaline etching is within a range of 5-60 g/L;
preferably, the etching solution A contains at least one of sodium hydroxide, potassium hydroxide, and sodium carbonate, and further preferably contains sodium hydroxide; and
preferably, a condition for the alkaline etching comprises: a temperature is within a range of 20-80°C and is preferably within a range of 40-60°C; and a time is within a range of 0.1-10 min and is preferably within a range of 0.5-3 min.

15. The method according to claim 9 or 10, wherein the concentration of an etching solution B used in the acidic etching is within a range of 1-200 g/L;
preferably, the etching solution B contains at least one of ferric chloride, hydrochloric acid, and cupric chloride, and further preferably contains ferric chloride and hydrochloric acid; and
preferably, a condition for the acidic etching comprises: a temperature is within a range of 5-40°C and is preferably within a range of 20-30°C; and a time is within a range of 1-60 min, and is preferably within a range of 15-30 min.

16. The method according to any one of claims 9 to 15, further comprising: dyeing and pore sealing a second surface of the metal hard anode oxidization layer (5) on which the resin film layer (3) is not formed.

17. A housing prepared by using the method according to any one of claims 9 to 16.

18. Use of the housing according to any one of claims 1 to 8, and 17 as an electronic product casing.

19. The use according to claim 18, wherein the electronic product casing is a mobile phone housing.
